(19) **Europäisches Patentamt / European Patent Office / Office européen des brevets**

(11) **EP 4 645 312 A1**

(12) **EUROPEAN PATENT APPLICATION**

(43) Date of publication:
05.11.2025 Bulletin 2025/45

(21) Application number: 24175972.9

(22) Date of filing: 15.05.2024

(51) International Patent Classification (IPC):
$G11C\ 5/02$ (2006.01)    $G11C\ 5/06$ (2006.01)
$G11C\ 7/18$ (2006.01)    $G11C\ 11/419$ (2006.01)
$G11C\ 17/18$ (2006.01)    $G11C\ 7/10$ (2006.01)

(52) Cooperative Patent Classification (CPC):
G11C 5/025; G11C 5/063; G11C 7/18;
G11C 11/419; G11C 17/18; G11C 7/10

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 02.05.2024 IN 202441034943

(71) Applicant: NXP B.V.
5656 AG Eindhoven (NL)

(72) Inventors:
• **Singh, Jainendra**
5656AG Eindhoven (NL)

• **Bhat, Ganesh**
5656AG Eindhoven (NL)
• **Mishra, Jwalant Kumar**
5656AG Eindhoven (NL)
• **Kohli, Rajat**
5656AG Eindhoven (NL)
• **Shahwaz, Mohd**
5656AG Eindhoven (NL)

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

(54) **MEMORY AND METHOD FOR CONSTRUCTING A MEMORY**

(57) A memory (300) comprising a multi stage data path-partitioning circuit, the memory (300, 400) comprising at least: a first data path level partitioning (310) comprising at least one input configured to input data to or output data from the memory (300, 400) via at least one global input-output circuit (360, 362); a second data path level partitioning (320) configured to input data to or output data from the memory (300, 400) between one of a plurality of write assist circuits (430, 431, 432, 433) and one of the at least one global input-output circuit (360, 362) wherein at least one of the plurality of write assist circuits (430, 431, 432, 433) and at least another of the plurality of write assist circuits (430, 431, 432, 433) are located in a central portion of an upper bitcell memory array (411, 412, 413, 414, 421, 422, 423, 424) and an lower bitcell memory array (415, 416, 417, 418, 425, 426, 427, 428) respectively; a third data path level partitioning (330) configured to input data to or output data from the memory (300, 400) between one of a plurality of column multiplexing circuitry and sense amplifier circuits (441, 442, 443, 444, 445, 446, 447, 448) and one of the plurality of write assist circuits (430, 431, 432, 433).

FIG. 4

EP 4 645 312 A1

**Description**

<u>Technical Field</u>

The technical field relates to a memory and a method for constructing a memory with improved internal data path partitioning. The technical field is applicable to, but not limited to, an arrangement of data path partitioning to reduce capacitance, whilst improving memory access time and cycle time.

<u>Background of the invention</u>

It is known that a bit cell, or a bitcell, is the basic building block of a memory array, and in turn, of a memory chip. Each cell comprises a small circuit with a memory element and a selector. The memory element stores data (either a logic '1' or a logic '0') and the selector activates the cell when accessed.

It is known that typical static random access memory (SRAM) / read only memory (ROM) use such bitcell memory arrays and they employ techniques for routing and using clock signals for accessing (reading from or writing to) the memory elements. In order to improve access to the memory, it is known that buffers are inserted into clock paths, often implemented to optimize and reduce resistance-capacitance (RC) delay. However, the use of buffers in memory increases the silicon area and gate delay of the memory. The insertion of such logic buffers in memory increases the gate delay as each logic buffer imparts some propagation delay of the clock signal. Furthermore, as more input gate capacitance and metal capacitance is introduced, the effect of these will directly increase the toggle power.

It is also known that typical SRAMs / ROMs use either a one-stage or a two-stage clock partitioning scheme. In a two-stage clock partitioning scheme, a first clock stage is driven by metal load, and a second stage is driven by a gate load. Here, bank clock decoding is used to select a top bank of memory or a bottom bank of memory, where a memory internal clock is the input signal. A memory 'address' signal is used to decode, at a memory bank level and memory row level and select between the top bank and bottom bank of the memory. In known memories, bank clock decoding generates another internal clock that is used as an input signal for word line decoding. Word line decoding is used to generate the word line to select a particular row of the memory. For word line decoding, a first input will be the internal clock that is generated using the bank clock decoding and a second input is the decoded address that us provided by pre decoders. However, this arrangement causes an increase in consumed clock toggle power.

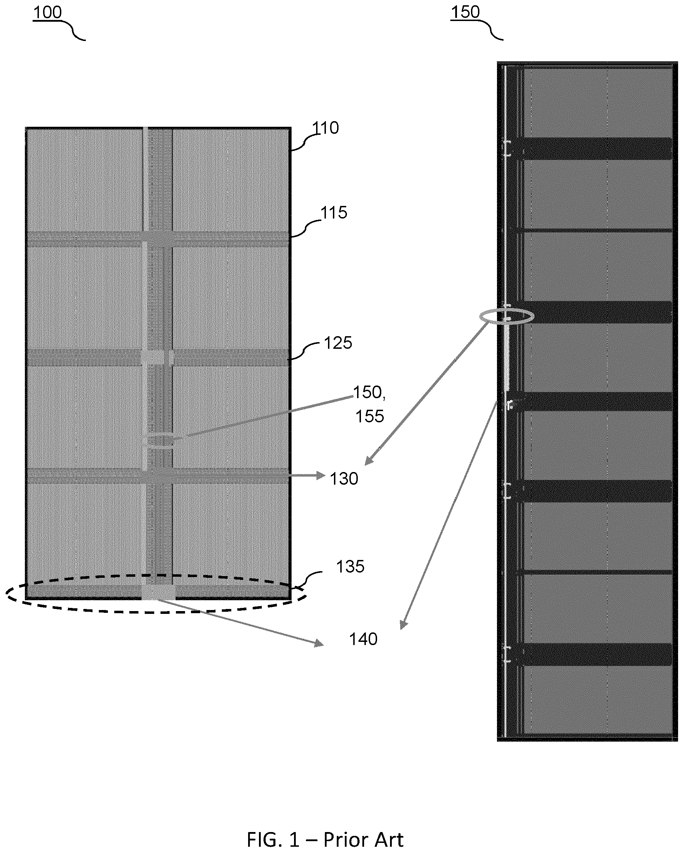

FIG. 1 illustrates two simplified known representations of a memory architecture 100, 150. A first memory 100 is shown with a SRAM 6T bit cell array 110 that is used to store data. The first memory 100 includes a column multiplexer function 115 that is configured to select a particular bit cell to perform a write/read operation. The first memory 100 and second memory 150 include memory areas dedicated for single-stage data partitioning and 1-stage bank clock decoding 130. The first memory 100 is shown having a charge pump circuit 125 that is configured to provide a negative boost to the bit line of bit cell and a global input/output (Gio) and write driver and write assist circuitry 135 located at the bottom of the memory and configured to provide the input to, and take the output from, the first memory 100. Internal clock signals are also shown at 150 and 155.

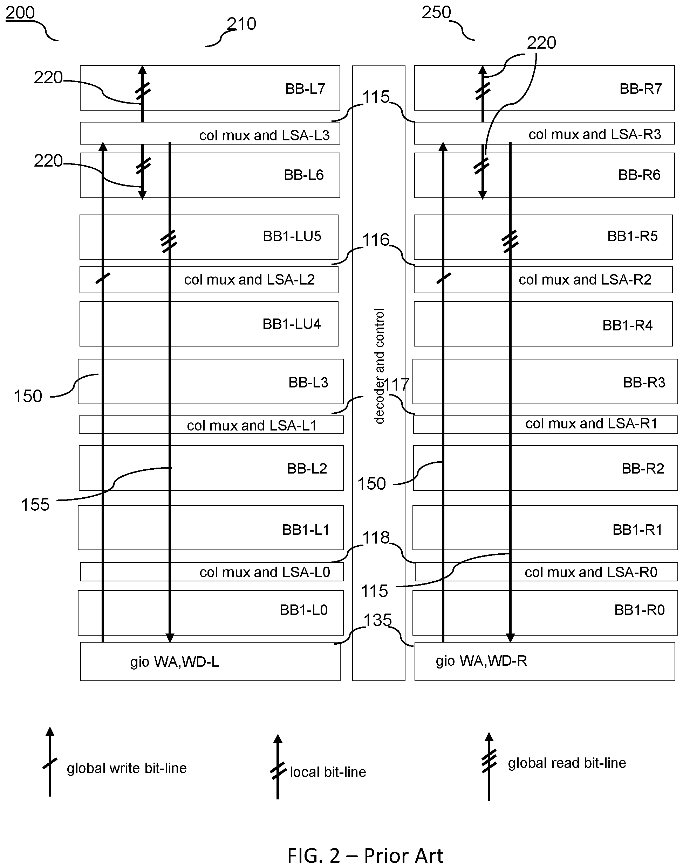

FIG. 2 also illustrates a known simplified representation of a memory architecture 200. The memory architecture 200 comprises a first bitcell memory bank containing an array of bitcells, sometimes referred to as a bitcell bank left (BB-L) quadrant 210 and a second bitcell memory bank, sometimes referred to as a bitcell bank right (BB-R) quadrant 250.

In an SRAM, the global input and out circuitry supporting write bit-line 150 and global read bit-line 155 contain latches for the input and output data, as well as a driver of latched input data and driver of output data. A local bit-line 220 travels vertically in a memory bank and is connected to pass-gate of each memory bit-cells in a column of a memory bank and then goes into bit-line multiplexing circuitry and local sense amplifier circuitry 115. The column multiplexing and local sense amplifier circuitry 115 connects one bit-line out of a group bit-line to global bit-line write 150 in a write cycle and a global read bit-line read 155 in a read operation. The local sense amplifier circuitry is used to amplify a voltage difference between the local bit-line and local bit-line bar and precharge or discharge global bit-line read based on data that is being read, which will ultimately be provided to an input port of an output driver.

In this single-stage data partitioning design of FIG. 2, the global write bit-line 150 and global read bit-line 155 each have a large data path run length to the furthest column multiplexing and sense amp circuitry 115, which increases the capacitive load and resistance. Due to the large capacitive load on global write bit-line 150, it requires a large capacitor in order to generate a negative voltage/boost for write assist operations, as well as increasing the write driver circuitry dynamic power. Due to the required large capacitor on global read bit-line 155, the read dynamic power and access time will also have large values. A clock pin 140 is provided to both memories to provide the memories with a system clock.

It is known that access-time optimization is challenging in lower technology nodes, which typically refers to smaller channel length of transistor that are below 28nm. RC delays are also becoming large generally as a result of both resistance and capacitance increases. The cross section of the metal in the memory and metal run length is becoming smaller, and hence resistance is increasing. Also, these developments cause a reduction in capacitance gate oxide thickness, and hence capacitance is increasing, which leads to very large access time. Furthermore, gate load is becoming larger as gate oxide thickness is reduced, as compared to higher technology nodes, as exemplified with the known capacitance formula

$$C = \varepsilon A/d \qquad [1]$$

where the capacitance is denoted by (C), $\varepsilon$ is the permittivity of the dielectric material, A is the area of one of the plates, and d is the distance between the plates (i.e., thickness of oxide).

Hence, toggling the capacitance is leading to increase in signal toggle power. Signal toggling power is power that is consumed while changing the state of input pins signal of the SRAM. Examples of input pins that affect this parameter are address, data, write enable etc. Each gate of transistor will have a gate capacitance load and that gate will be connecting as an input to the other device and hence toggling the input of that gate device will also toggle the gate capacitance load of that device, typically referred to as toggling capacitance. The toggling capacitance is the capacitance of a net which is getting pre-charge/discharge in operation of SRAM

As a consequence, toggling capacitance leads to increased toggle power, as capacitance load is directly connecting to the energy consumptions which is $E=(1/2) CV^2$, hence if capacitance will increase that means it will also lead to increase the toggle power.

Conventionally, it is known that there are 2 different schemes used for data partitioning. In a first scheme, data information is decoded at each bank level and charge pumps are placed at each bank, which leads to a larger silicon area. In a second scheme, data information is decoded at global input-output (Gio) level and charge pumps are placed at an input-output level once, which leads to higher active power, where overall active power is power consumed in a read/write operation of SRAM..

The inventors have recognised and appreciated the following influences that affect memory access time. SRAM active power is dependent on per bit power, where the per bit power refers to the additional active power consumed in performing read/write operation if bits of an SRAM configuration are increased by one. The total active power of a SRAM is the addition of per bit active power*total number of bits + static active power. To optimize per bit power, data path capacitance toggling needs to be reduced as any dynamic power = $C*V^2*f$ where C is total capacitance which is being precharge and V is supply voltage and f is frequency. The inventors have also recognised and appreciated that access time and clock power are identified as key optimization parameters of a memory. Internal clock distribution is one of the main contributors of access time. The clock toggle power during an active operation in memory is constant for given word-size, which has been identified by the inventors as a significant percentage of overall SRAM power consumption.

Accordingly, there is a need for a memory and method for reducing memory access time.

## Summary of the invention

The present invention provides a memory and method for constructing a memory architecture, as described in the accompanying claims. Specific embodiments of the invention are set forth in the dependent claims. These and other aspects of the invention will be apparent from and elucidated with reference to the embodiments described hereinafter.

According to a first aspect, there is provided a memory comprising a multi stage data path-partitioning circuit, the memory comprising at least: a first data path level partitioning comprising at least one input configured to input data to or output data from the memory via at least one global input-output circuit; a second data path level partitioning configured to input data to or output data from the memory between one of a plurality of write assist circuits and one of the at least one global input-output circuit wherein at least one of the plurality of write assist circuits and at least another of the plurality of write assist circuits are located in a central portion of an upper bitcell memory array and an lower bitcell memory array respectively; a third data path level partitioning (330) configured to input data to or output data from the memory between one of a plurality of column multiplexing circuitry and sense amplifier circuits and one of the plurality of write assist circuits.

In some examples, the memory comprises a central comprises a central portion comprising the multi level data path partitioning and wherein the at least one upper bitcell memory array and the at least one lower bitcell memory array comprise a bitcell memory array located on a first side of the memory and located on a second side of the memory.

In some examples, at least one of the plurality of write assist circuits and at least another of the plurality of write assist circuits are located in each side of a central portion of the upper bitcell memory array and the lower bitcell memory array respectively.-

In some example embodiments, the memory may wherein each of the plurality of write assist circuits is located equidistant from the at least one global input-output circuit and a respective one of the plurality of column multiplexing circuitry and sense amplifier circuits.

In some example embodiments, the first data path level partitioning is located with 40-60% of the at least one upper bitcell memory array above the first data path partitioning and 60-40% of the at least one lower bitcell memory array is below the first data path partitioning .

In an example, wherein the first data path level partitioning is located centrally between the at least one upper bitcell memory array and the at least one lower bitcell memory array. Further preferably, the location of the first data path level partitioning in the memory, the reduces a global read bit length by 3/8.

In an example embodiment, the second data path level partitioning is located between the first data path level partitioning and either the lower bitcell of the lower bitcell memory array or the upper bitcell of the upper bitcell memory array. Preferably, the second data path level partitioning is located within a 40-60% distance from the at first data path level partitioning and either the lower bitcell of the lower bitcell memory array or the upper bitcell of the upper bitcell memory array. Further preferably, the second data path level partitioning is located centrally with respect to the at first data path level partitioning (310) and either the lower bitcell of the lower bitcell memory array or the upper bitcell of the upper bitcell memory array.

In an example embodiment, the third data path level partitioning is located between the second data path level partitioning and either the lower bitcell of the lower bitcell memory array or the upper bitcell of the upper bitcell memory array. Preferably, the third data path level partitioning is located within a 40-60% distance from the second data path level partitioning and either the lower bitcell of the lower bitcell memory array or the upper bitcell of the upper bitcell memory array. Further preferably, the third data path level partitioning is located centrally with respect to the second data path level partitioning (320) and either the lower bitcell of the lower bitcell memory array or the upper bitcell of the upper bitcell memory array.

In an example embodiment, the memory is one of: a static random access memory, SRAM, a read only memory, ROM.

According to a second aspect, there is provided a method of constructing a memory comprising a multi stage data path-partitioning circuit, the memory comprising: at least a first data path level partitioning; a second data path level partitioning between one of a plurality of write assist circuits one of an at least one global input-output circuit and a third data path level partitioning located between one of a plurality of column multiplexing circuitry and sense amplifier circuits and one of the plurality of write assist circuits, wherein the method comprises: inputting data to or outputting data from the memory, from an input of the first data path level partitioning via at least one global input-output circuit; inputting or outputting data from the memory using the second data path level partitioning, inputting data to or outputting data from the memory using the third data path level partitioning.

## Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.

FIG. 1 illustrates two simplified known representations of a memory architecture.

FIG. 2 illustrates a simplified known representation of a memory architecture showing data paths and global read bit-line paths and global write bit-line paths.

FIG. 3 illustrates a simplified representation of a three-stage memory data path partitioning scheme with improved write assist circuitry placement, according to example embodiments.

FIG. 4 illustrates a representation of a three-stage memory data path partitioning scheme showing global read bit-line paths and global write bit-line paths and post latch data paths and local bit-line data paths, according to example embodiments.

FIG. 5 illustrates a simplified flowchart of a method of clock generation in a multi-stage memory partitioning scheme, according to example embodiments.

## Detailed description

The inventors have recognised and appreciated that a data paths in a memory are a major contributor of toggle power during an active operation in the memory. The toggle power helps to optimize power consumption and is useful for extending battery life and reducing overall power consumption. Furthermore, the inventors have recognised and appreciated that a charge-pump that is used to provide negative boost for write operation leads to increased silicon area as well as increased active power usage if placed locally or globally.

In response to these observations, the inventors recognised and appreciated that employing a partitioning scheme for a data path in the memory that ensures a total run length of metal line is reduced, in turn reduces the overall capacitance associated to the data path. As the capacitance of the data path is decreased, rise/fall times of the data path clock signal will also decrease, which will decrease overall delay of the timing path. Thus, the data partitioning scheme also helps to improve the memory access time and cycle time. Partitioning of data paths also helps to reduce resistance, which provides opportunities to reduce the amount of metal used in the data paths, e.g., a reduced width of the metal whilst concurrently improving RC delay performance and set-up time of data. In this context, set-up time of data to be stored in, say, an SRAM, refers to a minimum time before the arrival of an active edge of the clock when data should retain its state. A reduced width of the metal also helps to reduces the overall capacitance whilst keeping the data path run length the same. In this way resistance-capacitance (RC) delay will remain the same but the capacitance will be reduced. Examples herein described partition the data path into three levels.

In response to these observations, the inventors also recognised and appreciated that careful and strategic placement of write assist circuitry is employed at a second stage of data path, which reduces the capacitance requirement for generating negative voltage for the write assist circuitry and also optimizes RC delay of data path signals. This helps to reduce toggling capacitance to reduce active power of memory. Furthermore, careful and strategic placement of charge-pump circuitry may be employed to provide best gain with respect to reducing the overall memory silicon area and the dynamic power required to perform write operations.

In addition, the partitioning of the internal data paths into, say, three levels further comprises an optimal placement/location of the write assist circuitry, which a skilled artisan readily appreciates is a complex implementation challenge.

The following detailed description is merely illustrative in nature and is not intended to limit the embodiments of the subject matter or the application and uses of such embodiments. As used herein, the word "example" means "serving as an example, instance, or illustration." Any implementation described herein as an example is not necessarily to be construed as preferred or advantageous over other implementations.

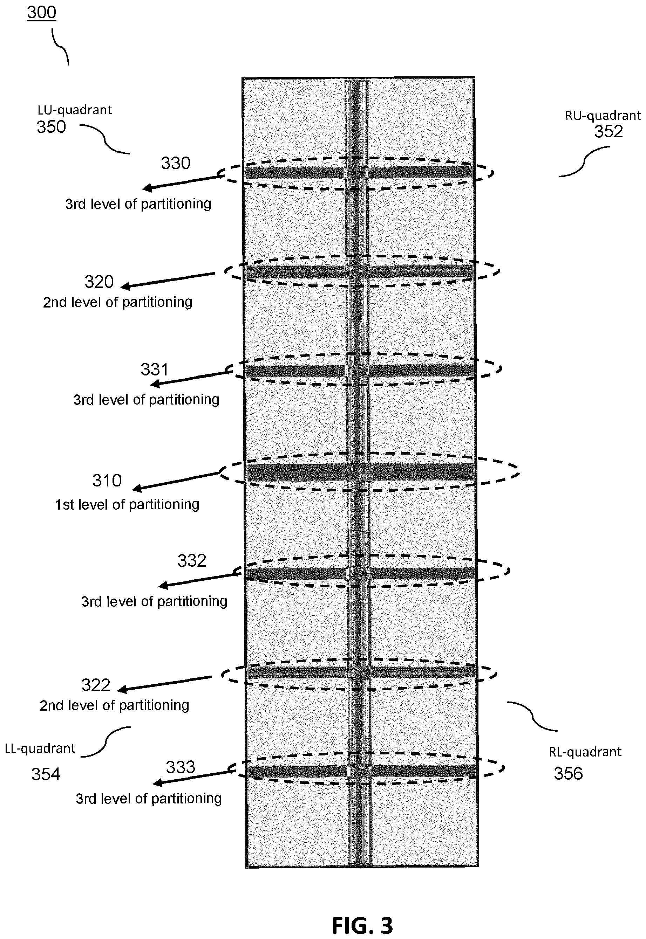

Referring now to FIG. 3, a simplified representation of a three-stage memory data path partitioning scheme 300 with improved write assist circuitry placement is illustrated, according to example embodiments. In particular, FIG. 3 illustrates and describes the three-stage memory in greater detail, in particular where a first partitioning data path level 310 is employed to parse bitcell bank (BB) memory areas into quadrants, i.e., a left upper quadrant 350, a right upper quadrant 352, a left lower quadrant 354 and a right lower quadrant 356. Two second partitioning data path levels 320, 322 are employed to divide each quadrant into two further bitcell bank (BB) memory arrays. Similarly, four further 'third' partitioning data path levels 330, 331, 332, 333 are employed to divide each half-quadrant into eight further bitcell bank (BB) memory arrays, resulting in 16 equal-sized bitcell bank (BB) memory arrays .

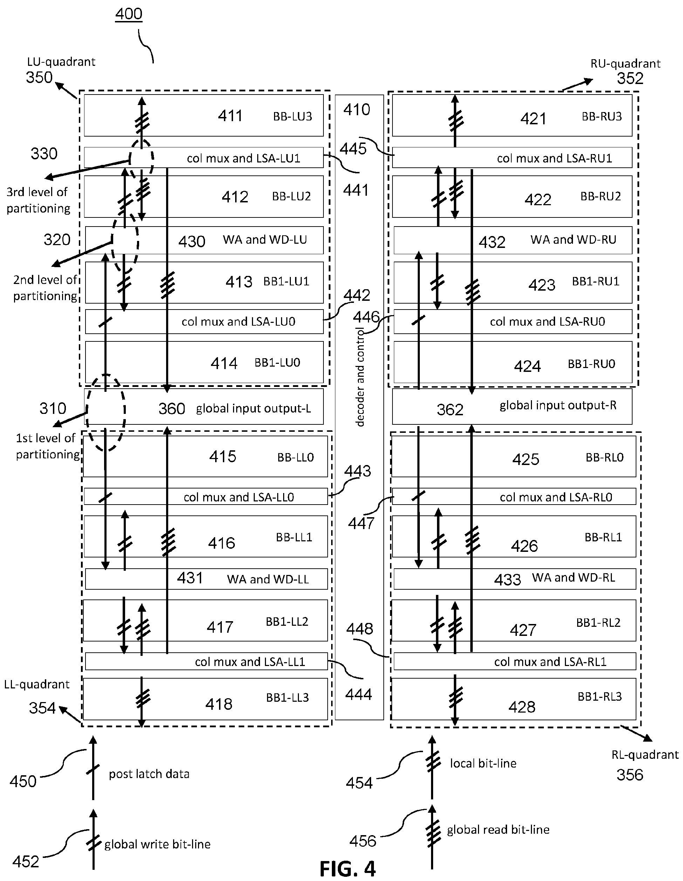

Referring now to FIG. 4, a further, more detailed representation of a three-stage memory data path partitioning scheme 400 is illustrated, showing global read bit-line paths and global write bit-line paths and post latch data paths and local bit-line data paths, according to example embodiments. As illustrated, the three-stage memory data path partitioning scheme 300 with improved write assist circuitry placement comprises decoder and control circuitry in a central portion 410 of the memory. Preferably, the memory is one or more of a static random access memory, SRAM, or a read only memory ROM.

The Decoder and control circuitry 410 have input latches of address input pins and other input pins for example: write enable, chip select margining control pins, decoding circuitry for address and internal clock generation buffers. Typically, the write enable pin is used to select read and write operations in the memory. The chip select input is used to enable or disable the memory for operation, and the margining pins are used to control margins. Decoding circuitry is preferably used to select a row in memory with the help of address pins. The Internal clock buffer is used to generate a internal clock signal which will travel vertically.

As illustrated, the memory (300, 400) comprises a multi stage data path-partitioning circuit, the memory (300, 400) comprising at least: a first data path level partitioning (310) comprising at least one input configured to input data to or output data from the memory (300, 400) via at least one global input-output circuit (360, 362); a second data path level partitioning (320) configured to input data to or output data from the memory (300, 400) between one of a plurality of write assist circuits (430, 431, 432, 433) and one of the at least one global input-output circuit (360, 362) wherein at least one of the plurality of write assist circuits (430, 431, 432, 433) and at least another of the plurality of write assist circuits (430, 431, 432, 433) are located in a central portion of an upper bitcell memory array (411, 412, 413, 414, 421, 422, 423, 424) and an lower bitcell memory array (415, 416, 417, 418, 425, 426, 427, 428) respectively; a third data path level partitioning (330) configured to input data to or output data from the memory (300, 400) between one of a plurality of column multiplexing circuitry and sense amplifier circuits (441, 442, 443, 444, 445, 446, 447, 448) and one of the plurality of write assist circuits (430, 431, 432, 433).

In an example embodiment, the memory (300, 400) comprises a central portion (410) comprising the multi level data path partitioning and wherein the at least one upper bitcell memory array (411, 412, 413, 414, 421, 422, 423, 424) and the at least one lower bitcell memory array (415, 416, 417, 418, 425, 426, 427, 428) comprise a bitcell memory array located on a first side (411, 412, 413, 414, 415, 416, 417, 418) of the memory (300, 400) and located on a second side (421, 422, 423, 424, 425, 426, 427, 428) of the memory (300, 400). Preferably, at least one of the plurality of write assist circuits (430, 431, 432, 433) and at least another of the plurality of write assist circuits (430, 431, 432, 433) are located in each side of a central portion of the upper bitcell memory array (350, 352) and the lower bitcell memory array (354, 356) respectively. Further preferably, each of the plurality of write assist circuits (430, 431, 432, 433) is located equidistant from the at least one global input-output circuit (360, 362) and a respective one of the plurality of column multiplexing circuitry and sense amplifier circuits (441, 442, 443, 444, 445, 446, 447, 448).

In the illustrated more detailed representation of a three-stage memory data path partitioning scheme 400, a first global input-output memory access circuit 360 is provided and a first (illustrated right)-hand portion of the memory is included to provide a second global input-output memory access 362. The global input output circuits 360, 362 are placed in the middle of the memory and used to generate data signals for either upper half OR the lower half of the memory 300, 400. This location of the global input output circuits 360, 362 provides the first level of partitioning of data 310. This first level partitioning will directly reduce the global read bit-line length 456 by 3/8, which will reduce the RC delay by 3/16 and reduce the metal load cap by 3/8, which reduces the read dynamic power and access time of memory 300, 400. In an ideal implementation, a truly central placement of the first level of partitioning provides the maximum advantage. However, it has been identified that a 20% margin on the central placement, i.e., 40-60%, provides a reasonable advantage. In an example, the first data path level partitioning (310) is located with 40-60% of the memory array (415, 416, 417, 418, 425, 426, 427, 428, 411, 412, 413, 414, 421, 422, 423, 424) above the first data path partitioning (310) and 60-40% of the memory array (411, 412, 413, 414, 421, 422, 423, 424, 415, 416, 417, 418, 425, 426, 427, 428) is below the first data path partitioning (310). Preferably, the first data path level partitioning is located centrally in the memory 300, 400 between the at least one upper bitcell memory array (411, 412, 413, 414, 421, 422, 423, 424) and the at least one lower bitcell memory array (415, 416, 417, 418, 425, 426, 427, 428).

In the illustrated more detailed representation of a three-stage memory data path partitioning scheme 400, write-driver and charge pump circuitry 430, 431, 432, 433 is placed substantially in a middle of the first half and second half of the memory (e.g., SRAM), in each quadrant. That is, write assist and charge pump circuit 430 is located in the LU quadrant 350, preferably in the centre of the quadrant 350. Write assist and charge pump circuit 432 is located in the RU quadrant 352, preferably in the centre of the quadrant 352. Write assist and charge pump circuit 431 is located in the LL quadrant 354, preferably in the centre of the quadrant 354. Write assist and charge pump circuit 433 is located in the RL quadrant 356, preferably, in the centre of the quadrant 356. This placement of the write assist and charge pump circuits leads to a reduction of data line run length. It also enables a decoding of upper or lower half data selection, which further reduces data toggling capacitance. Thus, in this manner, the write and write assist circuitry are placed in the middle of upper half and lower half of the memory, in each side of the memory. That is, with a write and write assist circuitry in each of the LU, RU, LL, and RL quadrants of the memory 300, 400. At these places, second level of partitioning of the data 320 is performed, where two global write bit-lines are being generated for each lower and upper half of the memory and travelling up-to the middle of each quarter of the memory on each side of the memory 300, 400. Again, in an ideal implementation, a truly central placement of the second level of data partitioning provides the maximum advantage. However, it has been identified that a 20% margin on the central placement, i.e., 40-60%, provides a reasonable advantage. In an example embodiment, the second data path level partitioning (320) is located between the first data path level partitioning (310) and either the lower bitcell of the lower bitcell memory array (415, 416, 417, 418, 425, 426, 427, 428).or the upper bitcell of the upper bitcell memory array (411, 412, 413, 414, 421, 422, 423, 424). Preferably, the second data path level partitioning (320) is located within a 40-60% distance from the at first data path level partitioning (310) and either the lower bitcell of the lower bitcell memory array (415, 416, 417, 418, 425, 426, 427, 428).or the upper bitcell of the upper bitcell memory array (411, 412, 413, 414, 421, 422, 423, 424). In an example, the second data path level partitioning (320) is located centrally with respect to the at first data path level partitioning (310) and either the lower bitcell of the lower bitcell memory array (415, 416, 417, 418, 425, 426, 427, 428) or the upper bitcell of the upper bitcell memory array (411, 412, 413, 414, 421, 422, 423, 424).

In the illustrated more detailed representation of a three-stage memory data path partitioning scheme 400, a third level of data partitioning 330 is also performed at the middle of each eighth of the memory where global write bit-lines 452 make connections with local bit-lines 454 of either upper half quarter or lower half quarter of the memory with column multiplexing circuitry and sense amplifier circuitry 441, 442, 443, 444, 445, 446, 447, 448. Here, local bit-lines 454 make connections with drain of pass gate of bit-cell. Again, in an ideal implementation, a truly central placement provides the maximum advantage. However, it has been identified that a 20% margin on the central placement, i.e., 40-60%, provides a reasonable advantage. In an example, the third data path level partitioning (330) is located between the second data path level partitioning (320) and either the lower bitcell of the lower bitcell memory array (415, 416, 417, 418, 425, 426, 427, 428) or the upper bitcell of the upper bitcell memory array (411, 412, 413, 414, 421, 422, 423, 424). Preferably, the third data path level partitioning (330) is located within a 40-60% distance from the at second data path level partitioning (320) and either the lower bitcell of the lower bitcell memory array (415, 416, 417, 418, 425, 426, 427, 428).or the upper bitcell of the upper bitcell memory array (411, 412, 413, 414, 421, 422, 423, 424). In a further example, wherein the third data path level partitioning (330) is located centrally with respect to the at second data path level partitioning (320) and either the lower bitcell of the lower bitcell memory array (415, 416, 417, 418, 425, 426, 427, 428).orthe upper bitcell of the upper bitcell memory array (411, 412, 413, 414, 421, 422, 423, 424).

In examples herein described, the write and write assist circuitry 430, 431, 432, 433 is placed at the second level of partitioning. In this manner, as identified by the inventors, the amount of capacitance needed for generating a negative voltage reduces as the write and write assist circuitry 430, 431, 432, 433 have to discharge the load of only one of the global write bit-line 452 and local bit-line 454.

The inventors have recognized and appreciated that the size of the charge pump capacitance required for generating particular values of negative boost depends upon the overall capacitance associated to metal, which will transfer negative boost to a pass-gate of a bit-cell on which data is being written. In this case, it is the capacitance associated to one global write bit line 452 and one local bit line 454 and this capacitance has reduced as compared to the known prior art of FIG. 1 and FIG. 2 due to the three-stage memory data path partitioning scheme 300, 400. In this manner, the global write bit-line 452 will have only a metal load of length of 1/8th of the height of the memory and the local bit-line 454 will have metal load of length of 1/8th of the height of the memory and drain capacitance load of the pass-gate of bit-cell. Hence, there is less requirement of the capacitance needed for write assist, which will in turn reduce the silicon area as well as the dynamic write power. Thus, in this manner, the overall capacitance load of global write lines 452 and global read bit-lines 456 is being reduced following the approaches described herein. These, in turn, reduce the time taken required to pre-charge the global write lines 452 and global read bit-lines 456 and help to reduce the cycle time of memory.

In the illustrated more detailed representation of a three-stage memory data path partitioning scheme 400, a first global input-output memory access 360 and a first (illustrated right)-hand portion of the memory is included to provide a second global input-output memory access 362 are placed in the middle of the memory and used to generate data signals for either upper half OR the lower half of the memory using post latched data and address information .This is first level of partitioning of data 310.

There are two Global read bit lines, one for upper half and other one for lower half of the memory. For upper half of the memory Global read bit line will travel from the top col mux and LSA circuitry and go each col mux and LSA circuitry in between and reach up to global input-output and For lower half of the memory Global read bit line will travel from the bottom col mux and LSA circuitry and go each col mux and LSA circuitry in between and reach up to global input-output.

Although the examples herein described have been described with reference to a three level partitioning of data paths that results in 16 substantially equal areas of bitcell bank memory areas, it is envisaged that other designs may be adopted to benefit from the concepts described herein, for example of the data path partitioning to be, say, 8 (roughly equal) areas, separated by the various functions/circuit accesses/logic, etc. Similarly, it is envisaged that other designs may be adopted to benefit from the concepts described herein, as would be understood by a skilled artisan, for example with implementations of a 6-region or 32-region design, as long as the respective bitcell bank memory areas and respective data path lengths are substantially equal across the number of, e.g., three, data path level partitioning scheme.

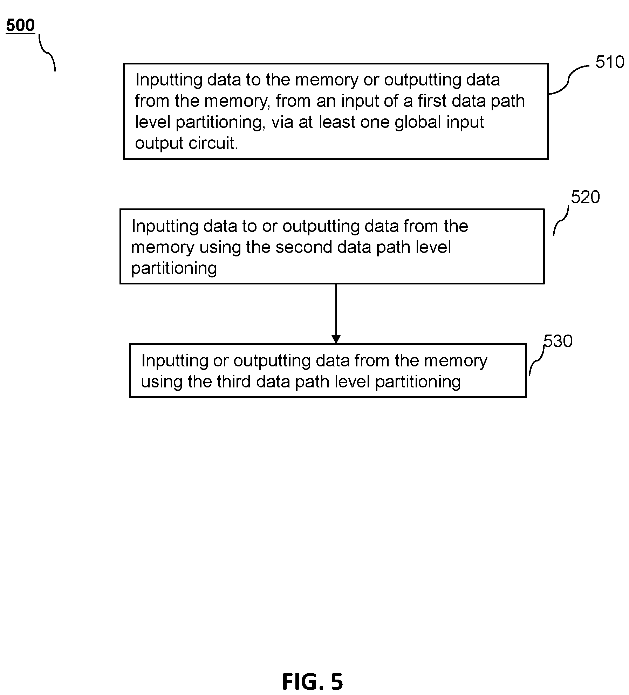

Referring now to FIG. 5, a simplified flowchart 500 of constructing a memory comprising a multi stage data path-partitioning circuit is illustrated, for example the multi-stage data path partitioning circuit 300, 400 in FIGs. 3 and 4, according to example embodiments. The memory comprises memory areas separated into quadrants, i.e., a left upper quadrant 350, a right upper quadrant 352, a left lower quadrant 354 and a right lower quadrant 356. Two second partitioning data path levels 320, 322 are employed to divide each quadrant into two further bitcell bank (BB) memory arrays. Similarly, four further 'third' partitioning data path levels 330, 331, 332, 333 are employed to divide each half-quadrant into eight further bitcell bank (BB) memory arrays, resulting in 16 equal-sized bitcell bank (BB) memory arrays.

The simplified flowchart 500 comprises, at 510 inputting data to the memory or outputting data from the memory, from an input of a first data path level partitioning, via at least one global input output circuit, then at 520 inputting data to or outputting data from the memory using the second data path level partitioning, finally at 530 inputting or outputting data from the memory using the third data path level partitioning

It is envisaged that the concepts herein described are suited for all memories, particularly those that benefit from improved access. Of course, the method can also be applied to other memory applications.

In the foregoing specification, the invention has been described with reference to specific examples of embodiments of the invention. It will, however, be evident that various modifications and changes may be made therein without departing from the scope of the invention as set forth in the appended claims and that the claims are not limited to the specific examples described above.

The connections as discussed herein may be any type of connection suitable to transfer signals from or to the respective nodes, units or devices, for example via intermediate devices. Accordingly, unless implied or stated otherwise, the connections may for example be direct connections or indirect connections. The connections may be illustrated or described in reference to being a single connection, a plurality of connections, unidirectional connections, or bidirectional connections. However, different embodiments may vary the implementation of the connections. For example, separate unidirectional connections may be used rather than bidirectional connections and vice versa. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals. Those skilled in the art will recognize that the architectures depicted herein are merely exemplary, and that in fact many other architectures can be implemented which achieve the same functionality.

Any arrangement of components to achieve the same functionality is effectively 'associated' such that the desired functionality is achieved. Hence, any two components herein combined to achieve a particular functionality can be seen as 'associated with' each other such that the desired functionality is achieved, irrespective of architectures or intermediary components. Likewise, any two components so associated can also be viewed as being 'operably connected,' or 'operably coupled,' to each other to achieve the desired functionality.

Furthermore, those skilled in the art will recognize that boundaries between the above-described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments. Also, for example in one embodiment, the illustrated examples may be implemented as circuitry located on a single integrated circuit or within a same device. In some examples, the various components within the de-warp processor can be realized in discrete or integrated component form, with an ultimate structure therefore being an application-specific or design selection. As the illustrated embodiments of the present invention may, for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention. A skilled artisan will appreciate that the level of integration of processor circuits or components may be, in some instances, implementation-dependent.

Also, for example, the examples, or portions thereof, may implemented as soft or code representations of physical circuitry or of logical representations convertible into physical circuitry, such as in a hardware description language of any appropriate type. Also, the invention is not limited to physical devices or units implemented in non-programmable hardware but can also be applied in programmable devices or units able to perform the desired sampling error and compensation by operating in accordance with suitable program code, such as minicomputers, personal computers, notepads, personal digital assistants, electronic games, automotive and other embedded systems, cell phones and various other wireless devices, commonly denoted in this application as 'computer systems'. However, other modifications, variations and alternatives are also possible. The specifications and drawings are, accordingly, to be regarded in an illustrative rather than in a restrictive sense.

In the claims, any reference signs placed between parentheses shall not be construed as limiting the claim. The word 'comprising' does not exclude the presence of other elements or steps then those listed in a claim. Furthermore, the terms 'a' or 'an,' as used herein, are defined as one or more than one. Also, the use of introductory phrases such as 'at least one' and 'one or more' in the claims should not be construed to imply that the introduction of another claim element by the indefinite articles 'a' or 'an' limits any particular claim containing such introduced claim element to inventions containing only one such element, even when the same claim includes the introductory phrases 'one or more' or 'at least one' and indefinite articles such as 'a' or 'an.' The same holds true for the use of definite articles. Unless stated otherwise, terms such as 'first' and 'second' are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

## Claims

1. A memory (300, 400) comprising a multi stage data path-partitioning circuit, the memory (300, 400) comprising at least:

   a first data path level partitioning (310) comprising at least one input configured to input data to or output data from the memory (300, 400) via at least one global input-output circuit (360, 362); a second data path level partitioning (320) configured to input data to or output data from the memory (300, 400) between one of a plurality of write assist circuits (430, 431, 432, 433) and one of the at least one global input-output circuit (360, 362) wherein at least one of the plurality of write assist circuits (430, 431, 432, 433) and at least another of the plurality of write assist circuits (430, 431, 432, 433) are located in a central portion of an upper bitcell memory array (411, 412, 413, 414, 421, 422, 423, 424) and an lower bitcell memory array (415, 416, 417, 418, 425, 426, 427, 428) respectively; and a third data path level partitioning (330) configured to input data to or output data from the memory (300, 400) between one of a plurality of column multiplexing circuitry and sense amplifier circuits (441, 442, 443, 444, 445, 446, 447, 448) and one of the plurality of write assist circuits (430, 431, 432, 433).

2. The memory (300) of claim 1, wherein the memory (300, 400) comprises a central portion (410) comprising the multi level data path partitioning and wherein the at least one upper bitcell memory array (411, 412, 413, 414, 421, 422, 423, 424) and the at least one lower bitcell memory array (415, 416, 417, 418, 425, 426, 427, 428) comprise a bitcell memory array located on a first side (411, 412, 413, 414, 415, 416, 417, 418) of the memory (300, 400) and located on a second side (421, 422, 423, 424, 425, 426, 427, 428) of the memory (300, 400).

3. The memory (30, 4000) of claim 2, wherein at least one of the plurality of write assist circuits (430, 431, 432, 433) and at least another of the plurality of write assist circuits (430, 431, 432, 433) are located in each side of a central portion of the upper bitcell memory array (350, 352) and the lower bitcell memory array (354, 356) respectively.

4. The memory (300) of any preceding claim, wherein each of the plurality of write assist circuits (430, 431, 432, 433) is located equidistant from the at least one global input-output circuit (360, 362) and a respective one of the plurality of column multiplexing circuitry and sense amplifier circuits (441, 442, 443, 444, 445, 446, 447, 448).

5. The memory of claim 2, wherein the first data path level partitioning (310) is located with 40-60% of the at bitcell memory array (411, 412, 413, 414, 421, 422, 423, 424, 415, 416, 417, 418, 425, 426, 427, 428) above the first data path partitioning (310) and 60-40% of the bitcell memory array (411, 412, 413, 414, 421, 422, 423, 424, 415, 416, 417, 418, 425, 426, 427, 428) is below the first data path partitioning (310).

6. The memory of claim 5, wherein the first data path level partitioning is located centrally between the at least one upper bitcell memory array (411, 412, 413, 414, 421, 422, 423, 424) and the at least one lower bitcell memory array (415, 416, 417, 418, 425, 426, 427, 428).

7. The memory of claim 5 or claim 6 wherein the location of the first data path level partitioning (310) in the memory reduces a global read bit length by 3/8.

8. The memory of claims 5-7 wherein the second data path level partitioning (320) is located between the first data path level partitioning (310) and either the lower bitcell of the lower bitcell memory array (415, 416, 417, 418, 425, 426, 427, 428).or the upper bitcell of the upper bitcell memory array (411, 412, 413, 414, 421, 422, 423, 424).

9. The memory of claim 8 wherein the second data path level partitioning (320) is located within a 40-60% distance from the at first data path level partitioning (310) and either a lower bitcell of the lower bitcell memory array (415, 416, 417, 418, 425, 426, 427, 428) or an upper bitcell of the upper bitcell memory array (411, 412, 413, 414, 421, 422, 423, 424).

10. The memory of claim 9 wherein the second data path level partitioning (320) is located centrally with respect to the first data path level partitioning (310) and eitherthe lower bitcell of the lower bitcell memory array (415, 416, 417, 418, 425, 426, 427, 428) or the upper bitcell of the upper bitcell memory array (411, 412, 413, 414, 421, 422, 423, 424).

11. The memory of any of claims 5 to 10 wherein the third data path level partitioning (330) is located between the second data path level partitioning (320) and either the lower bitcell of the lower bitcell memory array (415, 416, 417, 418, 425, 426, 427, 428) or the upper bitcell of the upper bitcell memory array (411, 412, 413, 414, 421, 422, 423, 424).

12. The memory of claim 11 wherein the third data path level partitioning (330) is located within a 40-60% distance from the second data path level partitioning (320) and either the lower bitcell of the lower bitcell memory array (415, 416, 417, 418, 425, 426, 427, 428).or the upper bitcell of the upper bitcell memory array (411, 412, 413, 414, 421, 422, 423, 424).

13. The memory of claim 12 wherein the third data path level partitioning (330) is located centrally with respect to the second data path level partitioning (320) and either the lower bitcell of the lower bitcell memory array (415, 416, 417, 418, 425, 426, 427, 428).or the upper bitcell of the upper bitcell memory array (411, 412, 413, 414, 421, 422, 423, 424).

14. The memory (300) of any preceding claim, wherein the memory is one of: a static random access memory, SRAM, a read only memory, ROM.

15. A method (700) of constructing a memory (300) comprising a multi stage data path-partitioning circuit, the memory comprising:

at least a first data path level partitioning;
a second data path level partitioning between one of a plurality of write assist circuits (430, 431, 432, 433) one of an at least one global input-output circuit (360, 362) and
a third data path level partitioning located between one of a plurality of column multiplexing circuitry and sense amplifier circuits (441, 442, 443, 444, 445, 446, 447, 448) and one of the plurality of write assist circuits (430, 431, 432, 433),
wherein the method comprises:

inputting data to or outputting data from the memory, from an input of the first data path level partitioning via at least one global input-output circuit (360, 362);
inputting or outputting data from the memory using the second data path level partitioning (320), and
inputting data to or outputting data from the memory using the third data path level partitioning (330).

FIG. 1 – Prior Art

FIG. 2 – Prior Art

FIG. 3

400

LU-quadrant
350

RU-quadrant
352

| 411 | BB-LU3 |

410

| 421 | BB-RU3 |

330

445

| col mux and LSA-LU1 |

| col mux and LSA-RU1 |

3rd level of
partitioning

441

| 412 | BB-LU2 |

| 422 | BB-RU2 |

320

| 430 | WA and WD-LU |

| 432 | WA and WD-RU |

2nd level of
partitioning

| 413 | BB1-LU1 |

442

446

| 423 | BB1-RU1 |

| col mux and LSA-LU0 |

| col mux and LSA-RU0 |

| 414 | BB1-LU0 |

| 424 | BB1-RU0 |

310

| 360 | global input output-L |

| 362 | global input output-R |

1st level of
partitioning

| 415 | BB-LL0 |

443

| 425 | BB-RL0 |

| col mux and LSA-LL0 |

447

| col mux and LSA-RL0 |

| 416 | BB-LL1 |

| 426 | BB-RL1 |

| 431 | WA and WD-LL |

| 433 | WA and WD-RL |

| 417 | BB1-LL2 |

448

| 427 | BB1-RL2 |

| col mux and LSA-LL1 |

| col mux and LSA-RL1 |

LL-quadrant
354

444

| 418 | BB1-LL3 |

| 428 | BB1-RL3 |

RL-quadrant
356

decoder and control

450 — post latch data

454 — local bit-line

452 — global write bit-line

456 — global read bit-line

**FIG. 4**

14

**500**

Inputting data to the memory or outputting data from the memory, from an input of a first data path level partitioning, via at least one global input output circuit. — 510

Inputting data to or outputting data from the memory using the second data path level partitioning — 520

Inputting or outputting data from the memory using the third data path level partitioning — 530

# FIG. 5

Europäisches
Patentamt

European
Patent Office

Office européen
des brevets

# EUROPEAN SEARCH REPORT

**Application Number**

EP 24 17 5972

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/185367 A1 (NGO HIEU T [US] ET AL) 3 July 2014 (2014-07-03) | 1-3,5-9, 15 | INV. G11C5/02 |
| A | * paragraphs [0037] - [0046]; figure 4 * ----- | 4,10-14 | G11C5/06 G11C7/18 |
| A | US 9 721 649 B1 (ZHOU SHIDONG [US] ET AL) 1 August 2017 (2017-08-01) * column 4, line 11 - column 5, line 15; figures 3, 4 * ----- | 1-15 | G11C11/419 G11C17/18 G11C7/10 |

**TECHNICAL FIELDS SEARCHED (IPC)**

G11C

The present search report has been drawn up for all claims

| Place of search | Date of completion of the search | Examiner |
|---|---|---|
| The Hague | 8 October 2024 | Vidal Verdú, Jorge |

EPO FORM 1503 03.82 (P04C01)

# EP 4 645 312 A1

## ANNEX TO THE EUROPEAN SEARCH REPORT
## ON EUROPEAN PATENT APPLICATION NO.

EP 24 17 5972

This annex lists the patent family members relating to the patent documents cited in the above-mentioned European search report.
The members are as contained in the European Patent Office EDP file on
The European Patent Office is in no way liable for these particulars which are merely given for the purpose of information.

08-10-2024

| Patent document cited in search report | Publication date | Patent family member(s) | Publication date |
|---|---|---|---|
| US 2014185367 A1 | 03-07-2014 | CN 104813404 A | 29-07-2015 |
| | | CN 107093440 A | 25-08-2017 |
| | | CN 113223577 A | 06-08-2021 |
| | | CN 113793628 A | 14-12-2021 |
| | | DE 112012007140 T5 | 20-08-2015 |
| | | KR 20150068477 A | 19-06-2015 |
| | | KR 20170066698 A | 14-06-2017 |
| | | KR 20190003864 A | 09-01-2019 |
| | | TW 201440049 A | 16-10-2014 |
| | | TW 201631578 A | 01-09-2016 |
| | | TW 201719653 A | 01-06-2017 |
| | | TW 201724105 A | 01-07-2017 |
| | | US 2014185367 A1 | 03-07-2014 |
| | | US 2015146478 A1 | 28-05-2015 |
| | | US 2016035414 A1 | 04-02-2016 |
| | | US 2017110184 A1 | 20-04-2017 |
| | | US 2017200490 A1 | 13-07-2017 |
| | | WO 2014105013 A1 | 03-07-2014 |
| US 9721649 B1 | 01-08-2017 | NONE | |

EPO FORM P0459

For more details about this annex : see Official Journal of the European Patent Office, No. 12/82

17